(19) Europäisches Patentamt

European Patent Office

Office européen des brevets

(11) Veröffentlichungsnummer: **0 308 649 B1**

(12) **EUROPÄISCHE PATENTSCHRIFT**

(45) Veröffentlichungstag der Patentschrift: **08.06.94**

(21) Anmeldenummer: **88113384.7**

(22) Anmeldetag: **18.08.88**

(51) Int. Cl.5: **H03H 17/02**

(54) **Digitaler Filterbaum.**

(30) Priorität: **24.09.87 DE 3732085**

(43) Veröffentlichungstag der Anmeldung:
**29.03.89 Patentblatt 89/13**

(45) Bekanntmachung des Hinweises auf die
Patenterteilung:
**08.06.94 Patentblatt 94/23**

(84) Benannte Vertragsstaaten:
**AT CH DE FR GB IT LI SE**

(56) Entgegenhaltungen:
**DE-A- 3 610 195**

**FREQUENZ, Band 42, Nr. 6-7, Juni/Juli 1988,
Seiten 181-189, Berlin, DE; H. GÖCKLER et al.:
"Digitaler Mehrträger-Demultiplexer für den
mobilen Satellitenfunk"**

(73) Patentinhaber: **ANT Nachrichtentechnik GmbH
Gerberstrasse 33
D-71522 Backnang(DE)**

(72) Erfinder: **Göckler, Heinz, Dipl.-Ing.
Elbinger Strasse 52
D-7150 Backnang(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen digitalen Filterbaum gemäß Oberbegriff des Anspruches 1 oder 2.

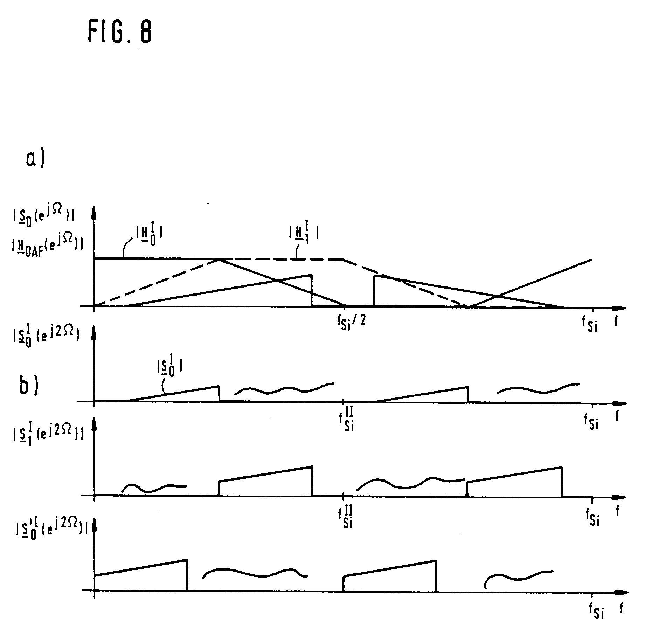

Ein solcher digitaler Filterbaum ist vorgeschlagen worden im Anspruch 7 der Hauptanmeldung (BK 86/25 entspr. P 36 10 195.8) sowie deren Figuren 8 und 9.

Die Blockstruktur dieser genannten Figur 8 kennzeichnet die sogenannte hierarchische Mehrstufenmethode HMM und ist so konzipiert, daß die angegebene Form für eine Kanalzahl entsprechend einer Zweierpotenz verwendbar ist.

Der vorliegenden Zusatzanmeldung lag die Aufgabe zugrunde, einen digitalen Filterbaum der eingangs genannten Art anzugeben, der es ermöglicht, die hierarchische Mehrstufenmethode HMM so zu modifizieren, daß die Gesamtanzahl der zu demultiplexenden Kanäle von der Zweierpotenz $L_0 = 2^i$ auf $L'$ vermehrt wird, wobei $L_0 < L' < 2L_0$ ist und wobei die Eingangsabtastfrequenz $f_{si} = 4L_0 \cdot B$ erhalten bleibt. Dies soll also ermöglicht werden, ohne daß der Demultiplexer für die nächsthöhere Zweierpotenz $2 \cdot L_0$ entworfen wird, wobei dann $2L_0 - L'$ Kanäle leerlaufen. Die Realisierung soll in einer möglichst unaufwendigen Weise erfolgen.

Diese Aufgabe wird gelöst durch die kennzeichnenden Merkmale der Ansprüche 1 und 2.

Der vorliegende digitale Filterbaum hat die Vorteile, daß die hierarchische Mehrstufenmethode HMM uneingeschränkt auf allgemeine Fälle anwendbar ist, d.h. auf Kanalzahlen auch ungleich einer Zweierpotenz. Die Realisierung erfolgt dabei in unaufwendiger Weise, und die Eingangsabtastfrequenz bleibt erhalten. Ein weiterer Vorteil ist darin zu sehen, daß die Struktur vereinheitlicht wird, indem ausschließlich identische HMM-Zellen benötigt werden, wodurch sich die Schaltung für eine integrierte Realisierung sehr gut eignet.

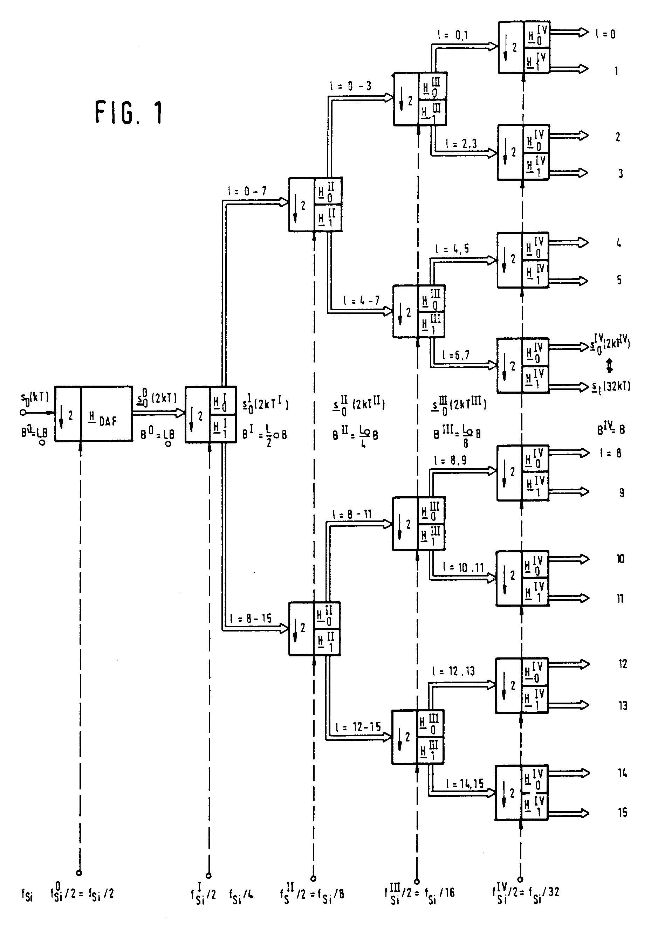

Es folgt nun die Beschreibung der Erfindung anhand der Figuren. Die Figuren 1 bis 4 stellen den Stand der Technik gemäß Hauptanmeldung dar für einen Demultiplexer für 16 Kanäle.

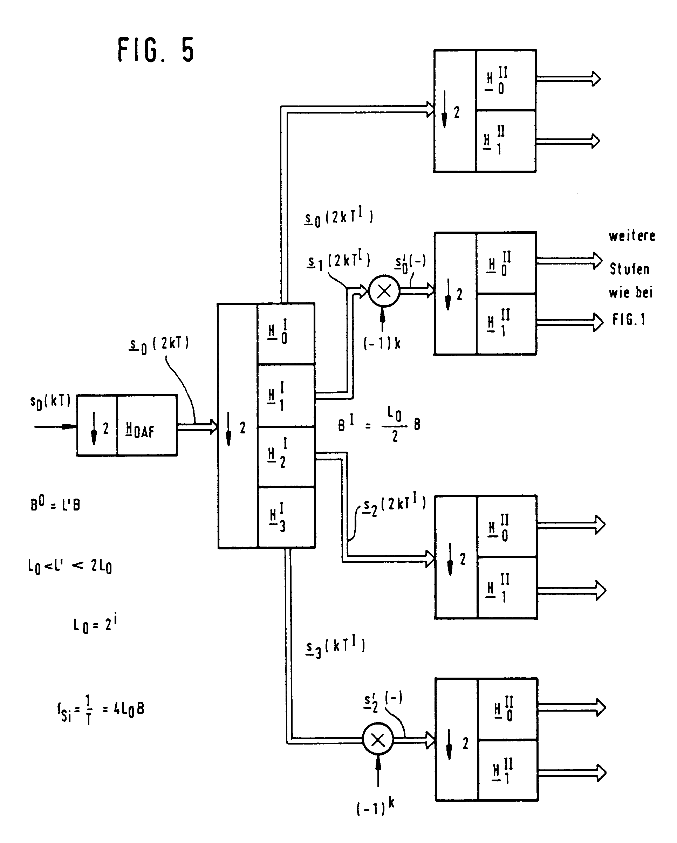

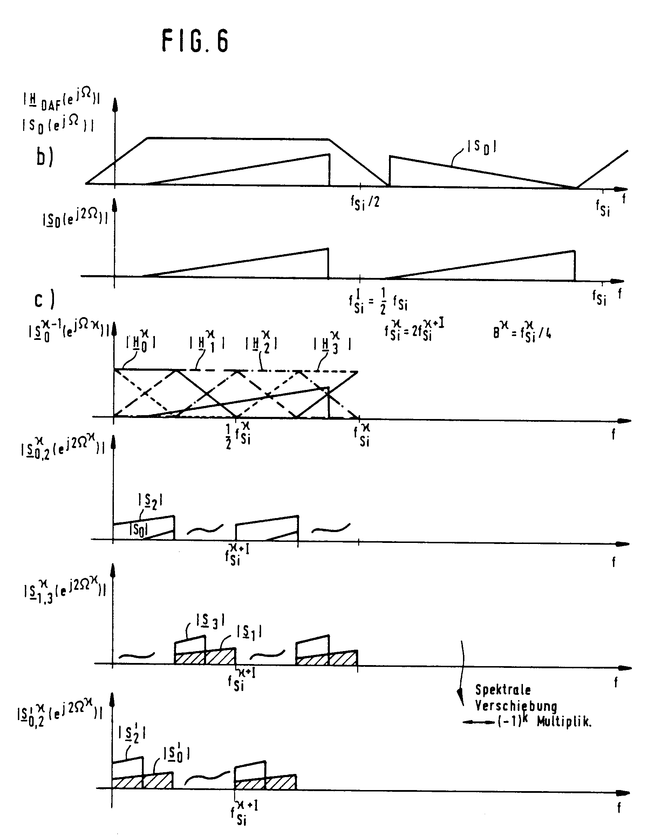

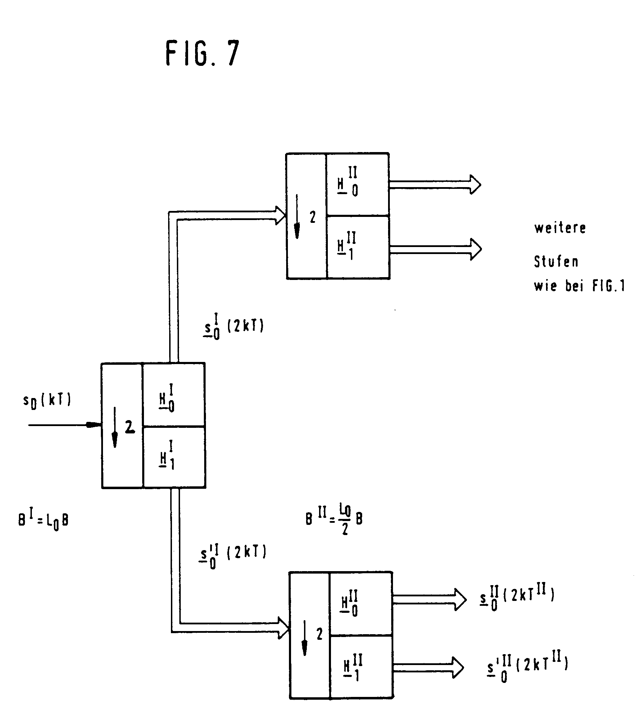

Die Figur 5 zeigt eine Blockstruktur gemäß Anspruch 2, die Figur 6 Frequenzspektren hierzu; die Figur 7 stellt eine Struktur gemäß Anspruch 1 dar, die hier zugehörenden Frequenzspektren sind in Figur 8 gezeichnet.

Die Figur 1 zeigt ein allgemeines Blockschaltbild für einen digitalen Filterbaum, der lauter identische Zellen $\underline{H}_0$ und $\underline{H}_1$ und am Eingang ein Digital Antialiasing Filter DAF enthält. Das aus dem reellwertigen Eingangssignal $\underline{s}_D(kT)$ mittels des DAF-Filters erzeugte komplexwertige Signal $\underline{s}_0(2kT)$ wird hierbei in Stufen jeweils mittels der genannten Filter $\underline{H}_0$ und $\underline{H}_1$ mit komplexen Koeffizienten und jeweils unter Halbierung der Abtastrate in die komplexen Einzelsignale zerlegt.

Die Figur 2 zeigt die spektralen Verhältnisse, wobei erkennbar ist, daß sowohl das DAF-Filter als auch alle Zellen $\underline{H}_\lambda$ vom selben Prototyp-Filter abgeleitet sind.

Im einzelnen sind dargestellt:

Figur 2a Spektrum des Halbband-Prototyp-Filters für alle HMM-Stufen und die DAF-Stufe.

Figur 2b spektrale Verhältnisse am DAF-Filter zuoberst für reelle Eingangsfolge $s_D(kT)$ und Übertragungsfunktion $|\underline{H}_{DAF}(e^{j\Omega})|$ darunter für komplexe Ausgangsfolge $\underline{s}_D(2kT)$ und darunter das frequenzverschobene Spektrum $\underline{S}_0^0(e^{j2\Omega})$.

In Figur 2c sind die spektralen Verhältnisse für die HMM-Stufen $\chi = $ I, II, III oder IV, also nach dem DAF-Filter aufgezeichnet.

$\lambda$ bedeutet hierbei die Schlitznummer der betrachteten HMM-Stufe, und $\chi - $ I kennzeichnet die vorhergehende Stufe und $\chi + $ I die folgende Stufe.

Zuoberst sind die Übertragungsfunktionen der beiden Filter $\underline{H}_0$ und $\underline{H}_1$ sowie die Spektren ihrer komplexwertigen Eingangssignale aufgezeichnet. Darunter ist das Spektrum des komplexwertigen Ausgangssignals des $\underline{H}_0$-Filters und wiederum darunter dasjenige des $\underline{H}_1$-Filters gezeichnet. Ganz unten ist das geschiftete Ausgangsspektrum gezeichnet, das aus

$$\underline{S}_1(e^{j2\Omega^\chi})$$

hervorgeht.

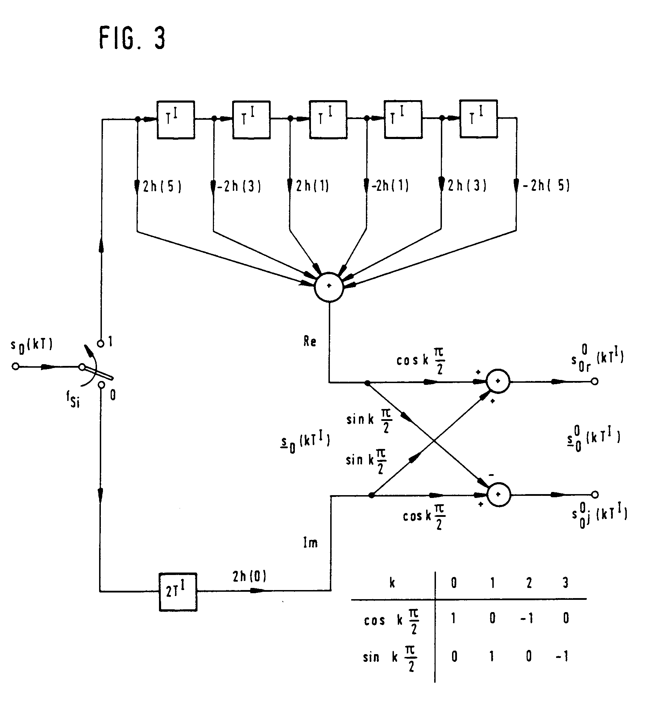

In Figur 3 ist ein Ausführungsbeispiel für eine DAF-Filter-Realisierung dargestellt, wobei für jedes Paar zweier aufeinander folgenden Abtastproben der Eingangsfolge ein komplexwertiger Ausgangsabtastwert geliefert wird.

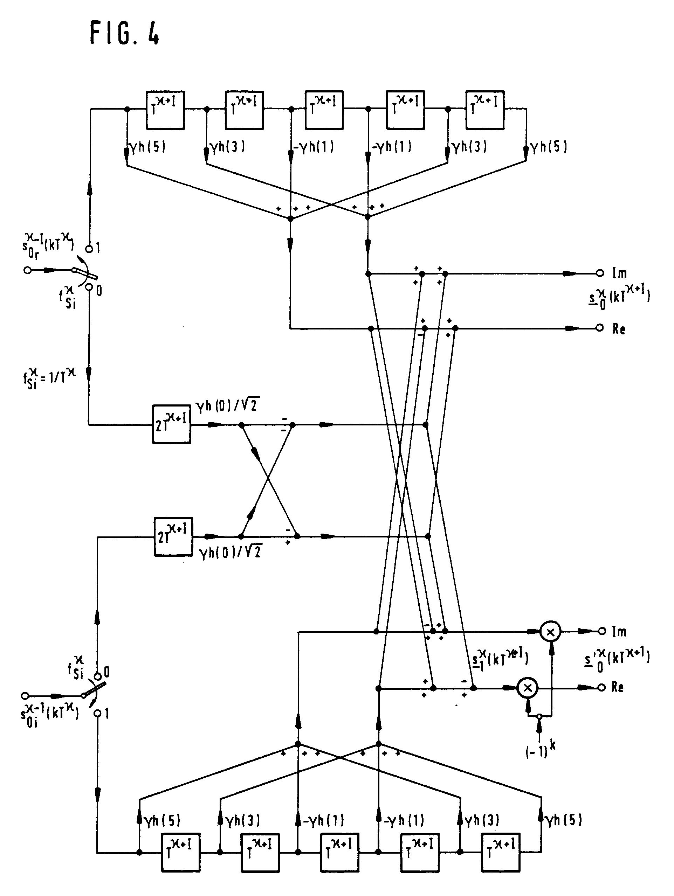

Als Beispiel für die Filter $\underline{H}_0$ und $\underline{H}_1$ ist in Figur 4 ein Blockschaltbild gezeichnet; nach ihm ist jedes der 15 identischen HMM-Filterzellen des Demultiplexers nach Figur 1 zu realisieren.

Die Figur 5 zeigt die Blockstruktur eines digitalen Filterbaums entsprechend vorliegender Anmeldung nach Patentanspruch 2; sie ist anstelle von Figur 1 zu setzen. Die zugehörige spektrale Darstellung ist aus Figur 6 ersichtlich. Das DAF-Filter ist identisch mit Figur 3 unter Weglassung der Multiplikationen mit sin $k\pi/2$ und cos $k\pi/2$ sowie der nachfolgenden Addierer. Die auf das DAF-Filter folgende Zelle mit 4 Ausgängen ist identisch mit dem Ausführungsbeispiel der Figur 9 der Hauptanmeldung, wobei alle Koeffizienten mit dem Faktor $\gamma/\sqrt{2}$ multipliziert werden könnten, mit $\gamma$ als allgemeinem Skalierungsfaktor. Die erforderlichen Multiplikationen mit $(-1)^k$ sind in Figur 5 enthalten. Die restlichen Zellen $\underline{H}_0$ und $\underline{H}_1$ sind identisch mit Figur 4.

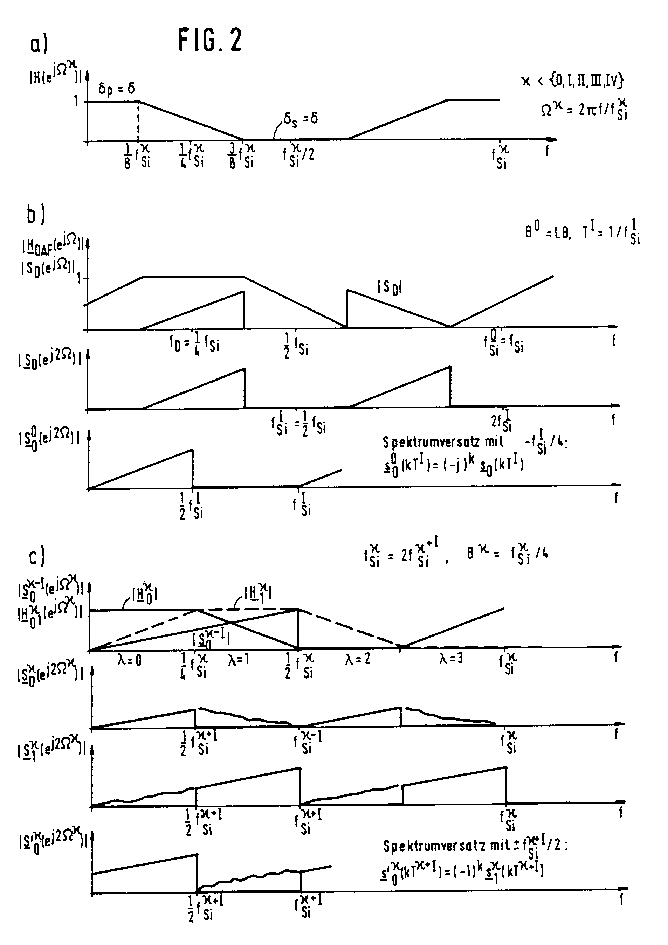

Die spektrale Darstellung der Figur 6 zeigt im Einzelnen folgendes: Die Übertragungfunktion des Prototyp-Filters für alle HMM-Zellen mit $\chi$ = I ..., aber nicht für das DAF-Filter, entspricht dem Diagramm nach Figur 2a.

Die Figur 6b zeigt Übertragungsfunktionen $|\underline{H}_{DAF}(e^{j\Omega})|$ und Signalspektren $|\underline{S}_D(e^{j\Omega})|$ bzw. $|\underline{S}_D(e^{j2\Omega})|$ des DAF-Filters. Im Vergleich zu Figur 2b ist festzustellen, daß im Gegensatz zur Halbbandversion der Figur 2b, wo Durchgangsbereich und Übergangsbereich sowie Sperrbereich gleichbreit sind, der Durchlaßbereich gemäß Figur 6b erweitert ist, dasselbe gilt für den Sperrbereich, und in entsprechender Weise ist der Übergangsbereich verkürzt. In diesem erweiterten Übertragungsbereich finden die Kanäle Platz, deren Anzahl über die Zweierpotenz $L_0$ hinausgeht. In dem unteren Diagramm der Figur 6b ist das komplexwertige Signalspektrum $|\underline{S}_D(e^{j2\Omega})|$ nach Halbierung der Abtastrate erkennbar.

In Figur 6c sind die Frequenzspektren in entsprechender Weise wie in Figur 2c gezeichnet, hier für die 4 Zellen der ersten Stufe, im oberen Diagramm die 4 Übertragungsfunktionen $\underline{H}_0$, $\underline{H}_1$, $\underline{H}_2$ und $\underline{H}_3$ sowie das Eingangssignalspektrum.

Darunter sind die Ausgangsspektren $\underline{S}_0$ und $\underline{S}_2$ gezeichnet, und im darunterliegenden Diagramm sind die Spektren $\underline{S}_1$ udn $\underline{S}_3$ gezeichnet. Im untersten Diagramm der Figur 6c sind die Spektren $\underline{S}_1$ und $\underline{S}_3$ nach spektraler Verschiebung in den Basisbereich gezeichnet.

Eine Blockschaltung, die besonders integrationsfreundlich ist, ist in Figur 7 dargestellt. Hier sind ausschließlich alle Stufen nur aus den beiden Filtern $\underline{H}_0$ und $\underline{H}_1$ realisiert. Alle Blöcke sind identisch mit denen der Figur 4. wobei in der Stufe I der Imaginärteil des Eingangssignals identisch Null ist. Eine solche Realisierung ist gleichermaßen möglich für $L' = L_0$. Zu betonen ist, daß in dem Blockschaltbild gemäß Figur 4 eine beliebige Skalierung möglich ist. Die spektralen Beziehungen sind der Figur 8 zu entnehmen, wobei die Übertragungsfunktion des Prototyp-Fitlers die gleiche ist wie diejenige des Prototyp-Filters gemäß Figur 2a und das Signalspektrum entsprechend der Kanalanzahl, d.h. beispielsweise ungleich einer Zweierpotenz, in entsprechender Weise im Bereich Null bis $f_{si}/2$ erweitert ist.

In Figur 8b sind die Signalspektren $\underline{S}_0$ und $\underline{S}_1$ untereinander aufgetragen, wobei in einem weiteren unteren Diagramm die Frequenzverschiebung des Spektrums $\underline{S}_1$ nach $\underline{S}'_0$ berücksichtigt ist. Die unter Figur 8b bezeichneten Signalspektren sind die Spektren der 1. Stufe ($\chi$ = I); die Frequenzspektren der folgenden Stufen sind in Figur 2c dargestellt, oder sie entsprechen der obigen Darstellung gemäß Figur 8b.

**Patentansprüche**

**1.** Digitaler Filterbaum, bestehend aus mehreren digitalen Filterbänken, die in einer Baumstruktur stufenweise sich verzweigend hintereinander angeordnet sind, wobei ausgehend von der 1. Stufe (Baumspitze) in der $\nu$-ten Stufe ($\nu$ = 1, 2, ...) eine Separierung in $L_\nu$ Einzelsignale erfolgt, wobei in der $\nu$-ten Stufe die Abtastrate jeweils um den Faktor $M_\nu \leq L_\nu$ vermindert wird, wobei die einzelne digitale Filterbank zur frequenzmäßigen Trennung eines mit der Abtastfrequenz $fA_\nu$ abgetasteten aus höchstens $L_\nu$ Einzelsignalen der Bandbreite B zusammengesetzten Frequenzmultiplexsignals dient, wobei in einem Prototyp-Filter Produktsummen

$$\underline{v}_\gamma(k,q) = \sum_{p=-\infty}^{+\infty} \underline{s}_\gamma(k-i) \cdot \underline{h}(i) \cdot e^{j\pi i/L}$$

mit

$i$ = $p \cdot L + q$ und
$q$ = 0, 1, 2, ... L-1,
$i,p,q$ = {0, 1, 2, 3,...},

aus dem mit der Abtastfrequenz $fA_\nu$ = $1/T_\nu$ abgetasteten Eingangssignal $\underline{s}_\nu(k)$, der endlich langen

3

Impulsantwort $\underline{h}$(i) für i = 0, 1, 2,..., N-1 des Prototyp-Filters und mit einem komplexen Drehfaktor einer Diskreten Fourier-Transformation (DFT) zur Bildung von L komplexen Ausgangssignalen

$$\underline{s1}_{\nu}(kM) = \sum_{q=0}^{L_{\nu}-1} \underline{v}_{\nu}(kM,q) \cdot e^{j2\pi q 1/L} = DFT\left\{\underline{v}_{\nu}(kM,q)\right\}$$

unterworfen sind, wobei die Verminderung der Abtastrate um den Faktor $M_{\nu} \leq L_{\nu}$ so erfolgt, daß nur jeder M-te Wert der Produktsummen in der DFT bearbeitet wird, für Kanalmittenfrequenzen $fl_{\nu} = l \cdot B_{\nu} + B_{\nu}/2$, wobei l die laufende Nummer des Kanals mit 0, 1, 2,... $L_{\nu}$-1 und $B_{\nu}$ die Kanalbandbreite sind, wobei das eingangsseitige Frequenzmultiplexsignal

$\underline{s}_D$ (k $\cdot$ $T_{\nu}$ ) = $sr_{\nu}$(k$T_{\nu}$) + j $\cdot$ $si_{\nu}$(k$T_{\nu}$) in Form zweier voneinander unabhängiger, zeitabhängiger Signalfolgen $sr_{\nu}$(k$T_{\nu}$) und $si_{\nu}$(k$T_{\nu}$) eingespeist wird, wobei die erste Folge als Realteil Re = $sr_{\nu}$(k$T_{\nu}$) und die zweite Folge als Imaginärteil Im = $si_{\nu}$(k$T_{\nu}$) der komplexwertigen, zeitabhängigen Eingangsgröße gilt und wobei j = $\sqrt{-1}$ und der Zeitfaktor k = ...-1, 0, +1,... sind, wobei für die Filterung des Realteils $sr_{\nu}$ und des Imaginärteils $si_{\nu}$ jeweils eine Kette von N-1 Verzögerungsgliedern der Verzögerungszeit $T_{\nu+1}$ verwendet wird, wobei die Abtastung des Inhalts der einzelnen unterschiedlich verzögerten Signalwerte der Teilfolgen beider Ketten jeweils mit einer Rate erfolgt, die um den Faktor $M_{\nu} \leq L_{\nu}$ vermindert ist, wobei diese so abgetasteten Signalwerte für Real- und Imaginärteil jeweils mit den Koeffizienten $\underline{h}$(i) multipliziert werden, wobei für Real- und Imaginärteil jeweils die Ausgänge der $L_{\nu}$-ten Multiplizierer zu den $L_{\nu}$ Produktsummen, nämlich den komplexen Zwischensignalen $\underline{v}_{\nu}$(kM,q) summierend zusammengefaßt werden und wobei die komplexen Zwischensignale $\underline{v}_{\nu}$(kM,q) vor der Diskreten Fourier-Transformation (DFT) jeweils mit komplexen Koeffizienten $e^{j\pi q/L}$ multipliziert werden, dadurch gekennzeichnet, daß für alle Stufen $\nu$ $M_{\nu}$ = 2 und $L_{\nu}$ = 4 festgelegt wird, wobei von den $L_{\nu}$ = 4 nur jeweils zwei Signale ausgenutzt werden,
daß das eingangsseitige Frequenzmultiplexsignal für die 1. Stufe reell ist und
daß die Abtastrate am Eingang dieser 1. Stufe halbiert wird (Figuren 7, 8).

2. Digitaler Filterbaum, bestehend aus mehreren digitalen Filterbänken, die in einer Baumstruktur stufenweise sich verzweigend hintereinander angeordnet sind, wobei ausgehend von der 1. Stufe (Baumspitze) in der $\nu$-ten Stufe ($\nu$ = 1, 2, ...) eine Separierung in $L_{\nu}$ Einzelsignale erfolgt, wobei in der $\nu$-ten Stufe die Abtastrate jeweils um den Faktor $M_{\nu} \leq L_{\nu}$ vermindert wird, wobei die einzelne digitale Filterbank zur frequenzmäßigen Trennung eines mit der Abtastfrequenz $fA_{\nu}$ abgetasteten aus höchstens $L_{\nu}$ Einzelsignalen der Bandbreite B zusammengesetzten Frequenzmultiplexsignals dient, wobei in einem Prototyp-Filter Produktsummen

$$\underline{v}_{\nu}(k,q) = \sum_{p=-\infty}^{+\infty} \underline{s}_{\nu}(k-i) \cdot \underline{h}(i) \cdot e^{j\pi i/L}$$

mit

i        = p $\cdot$ L + q und
q        = 0, 1, 2, ... L-1,
i,p,q    = {0, 1, 2, 3,...},
aus dem mit der Abtastfrequenz $fA_{\nu}$ = $1/T_{\nu}$ abgetasteten Eingangssignal $\underline{s}_{\nu}$(k), der endlich langen Impulsantwort $\underline{h}$(i) für i = 0, 1, 2,..., N-1 des Prototyp-Filters und mit einem komplexen Drehfaktor einer Diskreten Fourier-Transformation (DFT) zur Bildung von L komplexen Ausgangssignalen

$$\underline{s1}_{\nu}(kM) = \sum_{q=0}^{L_{\nu}-1} \underline{v}_{\nu}(kM,q) \cdot e^{j2\pi q 1/L} = DFT\left\{\underline{v}_{\nu}(kM,q)\right\}$$

unterworfen sind, wobei die Verminderung der Abtastrate um den Faktor $M_{\nu} \leq L_{\nu}$ so erfolgt, daß nur jeder M-te Wert der Produktsummen in der DFT bearbeitet wird, für Kanalmittenfrequenzen $fl_{\nu} = l \cdot B_{\nu}$

+ B$_\nu$/2, wobei I die laufende Nummer des Kanals mit 0, 1, 2,... L$_\nu$-1 und B$_\nu$ die Kanalbandbreite sind, wobei das eingangsseitige Frequenzmultiplexsignal $\underline{s}_D$(k • T$_\nu$) = sr$_\nu$(kT$_\nu$) + j • si$_\nu$(kT$_\nu$) in Form zweier voneinander unabhängiger, zeitabhängiger Signalfolgen sr$_\nu$(kT$_\nu$) und si$_\nu$(kT$_\nu$) eingespeist wird, wobei die erste Folge als Realteil Re = sr$_\nu$(kT$_\nu$) und die zweite Folge als Imaginärteil Im = si$_\nu$(kT$_\nu$) der komplexwertigen, zeitabhängigen Eingangsgröße gilt und wobei j = $\sqrt{-1}$ und der Zeitfaktor k = ...-1, 0, +1,... sind, wobei für die Filterung des Realteils sr$_\nu$ und des Imaginärteils si$_\nu$ jeweils eine Kette von N-1 Verzögerungsgliedern der Verzögerungszeit T$_{\nu+1}$ verwendet wird, wobei die Abtastung des Inhalts der einzelnen unterschiedlich verzögerten Signalwerte der Teilfolgen beider Ketten jeweils mit einer Rate erfolgt, die um den Faktor M$_\nu$ ≤ L$_\nu$ vermindert ist, wobei diese so abgetasteten Signalwerte für Real- und Imaginärteil jeweils mit den Koeffizienten $\underline{h}$(i) multipliziert werden, wobei für Real- und Imaginärteil jeweils die Ausgänge der L$_\nu$-ten Multiplizierer zu den L$_\nu$ Produktsummen, nämlich den komplexen Zwischensignalen $\underline{v}_\nu$(kM,q) summierend zusammengefaßt werden und wobei die komplexen Zwischensignale $\underline{v}_\nu$(kM,q) vor der Diskreten Fourier-Transformation (DFT) jeweils mit komplexen Koeffizienten e$^{j\pi q/L}$ multipliziert werden, dadurch gekennzeichnet,

daß für alle Stufen $\nu$ M$_\nu$ = 2 und L$_\nu$ = 4 festgelegt wird,

daß die 1. Stufe ($\nu$ = 0) eine echte Viererverzweigung bildet, indem ihre 4 Ausgangssignale ($\underline{s}_0$, $\underline{s}_1$, $\underline{s}_2$, $\underline{s}_3$) jeweils nachfolgenden Stufen zugeführt werden,

daß von den nachfolgenden Stufen jeweils nur zwei Ausgangssignale weiter verarbeitet werden,

daß das komplexe Eingangssignal $\underline{s}_D$ der 1. Stufe ($\nu$ = 0) mittels eines Vorfilters (DAF) durch Überabtastung mit 2fA aus einem reellwertigen Frequenzmultiplexsignal s$_D$(kT) erzeugt wird und

daß 2 der 4 Ausgangssignale der 1. Stufe ($\nu$ = 0), nämlich die beiden Teilspektren $\underline{S}_1$ und $\underline{S}_3$, die nicht direkt im Basisband 0 bis fsi$^{II}$/2 zu liegen kommen, spektral um (-1)$^k$ versetzt werden (Figuren 5, 6).

**Claims**

1. A digital filter tree composed of a plurality of digital filter banks arranged one behind the other in a tree structure in which they branch out in stages and, beginning with the first stage (top of the tree), a separation into L individual signals takes place in the $\nu^{th}$ stage ($\nu$ = 1, 2, ...), with the sampling rate being reduced by the factor M$_\nu$ ≤ L$_\nu$ in the $\nu^{th}$ stage and the individual filter bank serves to frequency separate a frequency multiplex signal which is sampled at the sampling rate fA$_\nu$ and is composed of at most L$_\nu$ individual signals of a bandwidth B, in a prototype filter, product sums

$$\underline{v}_\nu(k,q) = \sum_{p=-\infty}^{+\infty} \underline{s}_\nu(k-i) \cdot \underline{h}(i) \cdot e^{j\pi i/L}$$

where

i $\quad$ = p • L + q and
q $\quad$ = 0, 1, 2, ..., L-1
i, p, q $\quad$ = {0, 1, 2, 3, ...},

from the input signal $\underline{s}_\nu$(k) sampled at the sampling rate fA$_\nu$ = 1/T$_{\nu n}$, the finite length pulse response $\underline{h}$(i) for i = 0, 1, 2, ..., N-1 of the prototype filter and employing a complex rotation factor are subjected to a discrete Fourier transformation (DFT) to form L complex output signals

$$\underline{sl}_\nu(kM) = \sum_{q=0}^{L_\nu-1} \underline{v}_\nu(kM,q) \cdot e^{j2\pi ql/L} = DFT\{\underline{v}_\nu(kM,q)\}$$

with the reduction of the sampling rate by the factor M$_\nu$ ≤ L$_\nu$ being such that only every M$^{th}$ value of the product sums is processed in the DFT, for channel center frequencies fl$_\nu$ = l • B$_\nu$ + B$_\nu$/2, where l is the running number of the channel with 0, 1, 2, ..., L$_\nu$-1, and B$_\nu$ is the channel bandwidth, with the frequency multiplex signal $\underline{s}_D$ (k • T$_\nu$) = sr$_\nu$(kT$_\nu$) + j • si$_\nu$(kT$_\nu$) at the input being fed in in the form of two mutually independent, time dependent signal sequences sr$_\nu$(kT$_\nu$) and si$_\nu$(kT$_\nu$), with the first sequence being considered the real component Re = sr$_\nu$(kT$_\nu$) and the second sequence being considered the imaginary component Im = si$_\nu$(kT$_\nu$) of the complex, time dependent input value where j = $\sqrt{-1}$ and the time factor k = ..., -1, 0, +1, ...; a chain of N-1 delay members having a delay of T$_{\nu+1}$ is

employed for filtering each real component $sr_\nu$ and each imaginary component $si_\nu$, the sampling of the contents of the individual, differently delayed signal values of the partial sequences of both chains is effected at a rate which is reduced by a factor of $M_\nu \leq L_\nu$ and the thus sampled signal values for the real component and the imaginary component are each multiplied with the coefficient $\underline{h}(i)$; the outputs of the $L_\nu^{th}$ multiplier for each real component and imaginary component are summingly combined into the $L_\nu$ product sums, namely the complex intermediate signals $\underline{v}_\nu(kM,q)$, and said complex intermediate signals $\underline{v}_\nu(kM,q)$ are each multiplied, before the discrete Fourier transformation (DFT), with the complex coefficient $e^{j\pi q/L}$,

characterized in that

for all stages $\nu$, $M_\nu = 2$ and $L_\nu = 4$ are fixed, with only two signals of the $L_\nu = 4$ being utilized;

the frequency multiplex signal for the first stage at the input side is real and the sampling rate at the input of this first stage is cut in half (Figures 7, 8).

2. A digital filter tree composed of a plurality of digital filter banks arranged one behind the other in a tree structure in which they branch out in stages and, beginning with the first stage (top of the tree), a separation into $L_\nu$ individual signals takes place in the $\nu^{th}$ stage ($\nu = 1, 2, ...$), with the sampling rate being reduced by the factor $M_\nu \leq L_\nu$ in the $\nu^{th}$ stage and the individual filter bank serves to frequency separate a frequency multiplex signal which is sampled at the sampling rate $fA_\nu$ and is composed of at most $L_\nu$ individual signals of a bandwidth B, in a prototype filter, product sums

$$\underline{v}_\mathbf{v}(k,q) = \sum_{p=-\infty}^{+\infty} \underline{s}_\mathbf{v}(k-i) \cdot h(i) \cdot e^{j\pi i/L}$$

where

i $= p \cdot L + q$ and

q $= 0, 1, 2, ..., L\text{-}1$

i, p, q $= \{0, 1, 2, 3, ...\}$,

from the input signal $\underline{s}_\nu(k)$ sampled at the sampling rate $fA_\nu = 1/T_\nu$, the finite length pulse response $\underline{h}(i)$ for $i = 0, 1, 2, ..., N\text{-}1$ of the prototype filter and employing a complex rotation factor are subjected to a discrete Fourier transformation (DFT) to form L complex output signals

$$\underline{s}l_\mathbf{v}(kM) = \sum_{q=0}^{L_\mathbf{v}-1} \underline{v}_\mathbf{v}(kM,q) \cdot e^{j2\pi l/L} = DFT\left\{\underline{v}_\mathbf{v}(kM,q)\right\}$$

with the reduction of the sampling rate by the factor $M_\nu \leq L_\nu$ being such that only every $M^{th}$ value of the product sums is processed in the DFT, for channel center frequencies $fl_\nu = l \cdot B_\nu + B_\nu/2$, where l is the running number of the channel with $0, 1, 2, ..., L_\nu\text{-}1$, and $B_\nu$ is the channel bandwidth, with the frequency multiplex signal $\underline{s}_D(k \cdot T_\nu) = sr_\nu(kT_\nu) + j \cdot si_\nu(kT_\nu)$ at the input being fed in in the form of two mutually independent, time dependent signal sequences $sr_\nu(kT_\nu)$ and $si_\nu(kT_\nu)$, with the first sequence being considered the real component $Re = sr_\nu(kT_\nu)$ and the second sequence being considered the imaginary component $Im = si_\nu(kT_\nu)$ of the complex, time dependent input value where $j = \sqrt{-1}$ and the time factor $k = ..., -1, 0, +1, ...$; a chain of N-1 delay members having a delay of $T_{\nu+1}$ is employed for filtering each real component $sr_\nu$ and each imaginary component $si_\nu$, the sampling of the contents of the individual, differently delayed signal values of the partial sequences of both chains is effected at a rate which is reduced by a factor of $M_\nu \leq L_\nu$ and the thus sampled signal values for the real component and the imaginary component are each multiplied with the coefficient $\underline{h}(i)$; the outputs of the $L_\nu^{th}$ multiplier for each real component and imaginary component are summingly combined into the $L_\nu$ product sums, namely the complex intermediate signals $\underline{v}_\nu(kM,q)$, and said complex intermediate signals $\underline{v}_\nu(kM,q)$ are each multiplied, before the discrete Fourier transformation (DFT), with the complex coefficient $e^{j\pi q/L}$,

characterized in that,

for all stages $\nu$, $M_\nu = 2$ and $L_\nu = 4$ are fixed;

the first stage ($\nu = 0$) forms a true four-branch system in that its four output signals ($\underline{s}_0, \underline{s}_1, \underline{s}_2, \underline{s}_3$) are each fed to the subsequent stage;

6

only two output signals of each of the next following stages are processed further;

the complex input signal $\underline{s}_D$ of the first stage ($\nu = 0$) is produced by means of a prefilter (DAF) by resampling with 2fA from a real frequency multiplex signal $s_D(kT)$; and

two of the four output signals of the first stage ($\nu = 0$), namely the two partial spectra $\underline{S}_1$ and $\underline{S}_3$, which do not come to lie directly in the base band 0 to fsi$^{II}$/2, are spectrally offset by $(-1)^k$ (Figures 5, 6).

**Revendications**

**1.** Arbre de filtrage numérique, consistant en plusieurs banques de filtrage numériques, qui sont agencées dans une structure d'arbre, de façon étagée, en se ramifiant les unes derrière les autres, où, à partir du premier étage (sommet d'arbre) dans le $\nu$-ième étage ($\nu = 1, 2, ...$) une séparation dans des signaux individuels L a lieu, où, dans le $\nu$-ième étage la quote-part d'exploration est chaque fois réduite par le facteur $M_\nu \leq L_\nu$, où la banque de filtrage numérique individuelle sert pour la séparation selon la fréquence d'un signal multiplexeur de fréquence composé d'au plus $L_\nu$ signaux individuels de largeur de bande B explorés avec la fréquence d'exploration $fA_\nu$, où dans un filtre prototype, des sommes de produit

$$\underline{v}_\nu(k,q) = \sum_{p=-\infty}^{+\infty} \underline{s}_\nu(k-i) \cdot \underline{h}(i) \cdot e^{j\pi i/L}$$

avec

i $= p \cdot L + q$ et

q $= 0, 1, 2, ... L-1,$

i,p,q $= \{0, 1, 2, 3, ...\}$,

à partir du signal d'entrée $\underline{S}_\nu$ (k) exploré avec la fréquence d'exploration $fA_\nu = 1/T_\nu$, sont soumises à la réponse d'impulsion longues finales $\underline{h}(i)$ pour $i = 0, 1, 2, ..., N-1$ du filtre prototype et, avec un facteur de rotation complexe, à une transformation de Fourier discrète (DFT) pour la formation de signaux de sortie complexes L

$$\underline{sl}_\nu(kM) = \sum_{q=0}^{L_\nu-1} \underline{v}_\nu(kM,q) \cdot e^{j2\pi ql/L} = DFT\left\{\underline{v}_\nu(kM,q)\right\}$$

où, la diminution de la quote-part d'exploration a lieu ainsi avec le facteur $M_\nu \leq L_\nu$, que seulement chaque valeur Mième des sommes de produit dans le DFT est triaté, pour des fréquences moyennes de canal $fl_\nu = 1 \cdot B_\nu + B_\nu /2$, ou 1 est le nombre courant du canal avec $0, 1, 2, ... L_\nu$ -1 et $B_\nu$ est la largeur de bande de canal, où le signal multiplex de fréquence du côté d'entrée $\underline{S}_D (k \cdot T_\nu) = sr_\nu (kT_\nu ) + j \cdot si_\nu (kT_\nu )$ est mis en mémoire sous forme de deux suites de signal $sr_\nu (kT_\nu )$ et si $\nu (kT_\nu )$ indépendantes l'une de l'autre, fonction du temps, où, la première suite vaut comme partie réelle Re $= sr_\nu (kT_\nu )$ et la deuxième suite vaut comme partie imaginaire Im $= si_\nu (kT_\nu )$ de la grandeur d'entrée fonction du temps, de valeur complexe, et, où, $j = \sqrt{-1}$ et le facteur de temps $k = ...-1, 0, +1, ...,$ où, pour le filtrage de la partie réelle $sr_\nu$ et de la partie imaginaire $si_\nu$, chaque fois, une chaîne de N-1 membres de retard du temps de retard $T_\nu$ +I est employée, où, l'exploration du contenu des valeurs de signal retardées différemment, individuelles, des suites partielles des deux chaînes a lieu chaque fois avec une quote-part, qui est réduite par le facteur $M_\nu \leq L_\nu$, où, ces valeurs de signal ainsi explorées sont multipliées pour partie réelle et partie imaginaire, chaque fois, avec les coefficients $\underline{h}(i)$, où, pour la partie réelle et la partie imaginaire, chaque fois, les sorties des multiplicateurs $L_\nu$ ième sont réunies par sommation aux $L_\nu$ sommes de produit, c'est-à-dire aux signaux intermédiaires complexes $\underline{v}_\nu$ (kM, q), et, où, les signaux intermédiaires complexes $\underline{v}_\nu$ (kM, q), avant la transformation de Fourier discrète (DFT), sont, chaque fois, multipliés avec des coefficients complexes $e^{j\pi q/L}$, caractérisé en ce que pour tous les étages $\nu$, $M_\nu = 2$ et $L_\nu = 4$ sont déterminés, où, des $L_\nu = 4$ seulement, chaque fois, deux signaux sont utilisés,

que le signal multiplex de fréquence côté entrée pour le première étage est réel et

que la quote-part d'exploration à l'entrée de ce premier étage est partagée en deux (figures 7, 8).

**2.** Arbre de filtrage numérique consistant en plusieurs banques de filtrage numériques, qui sont agencées de façon étagée en se ramifiant les unes derrière les autres dans une structure d'arbre, où, en partant du premier étage (sommet d'arbre), dans le $\nu$-ième étage ( $\nu$ = 1, 2, ...) une séparation en $L_\nu$ signaux individuels a lieu, où, dans le $\nu$-ième étage, la quote-part d'exploration, chaque fois, est diminuée par le facteur $M_\nu \leq L_\nu$ , où, la banque de filtrage numérique individuelle sert pour la séparation en fonction de la fréquence d'un signal multiplex de fréquence exploré avec la fréquence d'exploration $fA_\nu$ , composée à partir d'au plus $L_\nu$ signaux individuels de la largeur de bande B, où, dans un filtre prototype, des sommes de produit,

$$\underline{v}_\nu(k,q) = \sum_{p=-\infty}^{+\infty} \underline{s}_\nu(k-i) \cdot \underline{h}(i) \cdot e^{j\pi i/L}$$

avec

i $= p \cdot L + q$ et

q $= 0, 1, 2, ... L-1,$

i,p,q $= \{0, 1, 2, 3, ...\},$

à partir du signal d'entrée $\underline{s}_\nu$ (k) exploré avec la fréquence d'exploration $fA_\nu$ = $1/T_\nu$ , sont soumises à la réponse d'impulsions longues finales $\underline{h}(i)$ pour i = 0, 1, 2, ..., N-1 du filtre prototype et, avec un facteur de rotation complexe, à une transformation de Fourier discrète (DFT) pour la formation de L signaux de sortie complexes

$$\underline{sl}_\nu(kM) = \sum_{q=0}^{L_\nu-1} \underline{v}_\nu(kM,q) \cdot e^{j2\pi ql/L} = DFT\left\{\underline{v}_\nu(kM,q)\right\}$$

où, la diminution de la quote-part d'exploration par le facteur $M_\nu \leq L_\nu$ a lieu ainsi, que seulement chaque Mième valeur des sommes de produit est traitée dans la DFT, pour des fréquences centrales de canal $fl_\nu$ = 1 $\cdot$ $B_\nu$ + $B_\nu$ /2, où, l est le nombre courant du canal avec 0, 1, 2, ... $L_\nu$ -1 et $B_\nu$ est la largeur de bande de canal, où, le signal multiplex de fréquence côté entrée $\underline{s}_D$ (k $\cdot$ $T_\nu$ ) = sr ($kT_\nu$ ), + j $\cdot$ $si_\nu$ ($kT_\nu$ ) est alimenté sous forme de deux suites de signal indépendantes l'une de l'autre, fonction du temps, $sr_\nu$ ($kT_\nu$ ) et $si_\nu$ ($kT_\nu$ ), où, la première suite est valable comme partie réelle Re = $sr_\nu(kT_\nu)$ et la deuxième suite vaut comme partie imaginaire Im = $si_\nu$ ($kT_\nu$ ) de la grandeur d'entrée fonction du temps, de valeur complexe, et, ou, j = $\sqrt{-1}$ et le facteur de temps k = ...-1, 0, +1, ..., où, pour le filtrage de la partie réelle $sr_\nu$ et de la partie imaginaire $si_\nu$ , chaque fois, une chaîne de N-1 membres de retardement du temps de retardement $T_\nu$ +I est employé, où, l'exploration du contenu des valeurs de signal retardées individuellement différemment des suites partielles des deux chaînes, chaque fois, a lieu avec une quote-part, qui est réduite par le facteur $M_\nu \leq L_\nu$ , où, ces valeurs de signal ainsi explorées pour partie réelle et partie imaginaire sont, chaque fois, multipliées avec les coefficients $\underline{h}(i)$, où, pour partie réelle et partie imaginaire, chaque fois, les sorties des $L_\nu$-ième multiplicateurs, sont réunies par sommation aux $L_\nu$ sommes de produit, précisément aux signaux intermédiaires complexes $\underline{v}_\nu$ (kM, q), et, où, les signaux intermédiaires complexes $\underline{v}_\nu$ (kM, q), avant la transformation de Fourier discrète (DFT), sont, chaque fois, multipliés avec des coefficients complexes $e^{j\pi q/L}$, caractérisé

en ce que pour tous les étages $\nu$ , $M_\nu$ = 2 et $L_\nu$ = 4 sont déterminés, que le premier étage ( $\nu$ = 0) forme une véritable quadruple bifurcation, en ce que ses quatre signaux de sortie ($\underline{S}_0$, $\underline{S}_1$, $\underline{S}_2$, $\underline{S}_3$) sont, chaque fois, amenés à des étages suivants, que des étages suivants, chaque fois, seuls deux signaux de sortie sont à nouveau traités,

que le signal d'entrée complexe $\underline{S}_D$ du premier étage ( $\nu$ = 0), est engendré au moyen d'un préfiltre (DAF) par surexploration avec $2fA$ à partir d'un signal multiplex de fréquence de valeur réelle $\underline{S}_D$ (kT) et

que 2 des 4 signaux de sortie du premier étage ($\nu$ = 0), précisément les deux spectres partiels $\underline{S}_1$ et $\underline{S}_3$, qui ne viennent pas se situer directement dans la bande de base 0 à $fsi^{II}/2$, sont décalés spectralement de $(-1)^k$ (figures 5, 6).

FIG. 1

FIG. 2

# FIG. 3

# FIG. 4

# FIG. 5

$$\underline{s}_0(2kT^I)$$

$$\underline{s}_1(2kT^I)$$

$$\underline{s}_0^t(-)$$

weitere

Stufen

wie bei

FIG.1

$$\underline{s}_0(2kT)$$

$$s_0(kT)$$

$$B^I = \frac{L_0}{2}B$$

$$B^0 = L'B$$

$$\underline{s}_2(2kT^I)$$

$$L_0 < L' < 2L_0$$

$$L_0 = 2^i$$

$$\underline{s}_3(kT^I)$$

$$f_{Si} = \frac{1}{T} = 4L_0 B$$

$$\underline{s}_2^t(-)$$

$$(-1)^k$$

FIG. 6

# FIG. 7

weitere

Stufen

wie bei FIG.1

$\underline{s}_0^I (2kT)$

$s_0(kT)$

$B^I = L_0 B$

$\underline{s}_0'^{II} (2kT)$

$B^{II} = \frac{L_0}{2} B$

$\underline{s}_0^{II} (2kT^{II})$

$\underline{s}_0'^{II} (2kT^{II})$

## FIG. 8

a)

b)